# EUROPEAN PATENT APPLICATION

(11) **EP 4 664 722 A1**
(43) Date of publication of application: **17.12.2025**
(21) Application number: 25182519.6
(22) Date of filing: 12.06.2025
(51) Int. Cl.: H02J 7/00, H02J 9/06

(54) **UNINTERRUPTED SWITCHING CIRCUIT DEVICE AND SYSTEM**

(30) Priority: 13.06.2024 CN 202410756278
(71) Applicant: ChinaBridge (Shenzen) Medical Technology Co., Ltd., Shenzhen, Guangdong 518102 (CN)
(72) Inventor: LI, Yijiang, Shenzhen, Guangdong 518102 (CN); WU, Guangning, Shenzhen, Guangdong (CN)
(74) Representative: Pfenning, Meinig & Partner mbB

(57) **Abstract**

A uninterrupted switching circuit includes a control unit, a first connector, and at least two second connectors. The first connector is configured to be connected to a target device, and the at least two second connectors are respectively configured to be connected to power supply devices. The first connector is connected to the at least two second connectors, respectively, to enable the power supply devices to supply power to the target device through the first connector. The control unit is connected to the first connector and the at least two second connectors, respectively. The control unit is configured to determine whether another power supply device connected to the target device through one of the second connectors is normal, and the control unit is configured to feed back a normal power supply signal to the target device, thereby avoiding an abnormality alarm from being issued by the target device.

## Description

### CROSS REFERENCE TO RELATED APPLICATIONS

The present application claims priority to Chinese Patent Application No. 202410756278.5, filed June 13, 2024, the entire disclosure of which is incorporated herein by reference.

### TECHNICAL FIELD

Embodiments of the present application belong to the medical device field, specifically relating to an uninterrupted switching circuit, a device, and a system.

### BACKGROUND ART

In clinical emergency treatment of critically ill patients with severe cardiopulmonary failure, extracorporeal membrane oxygenation (ECMO) is used to provide continuous extracorporeal respiratory and circulatory support for the patient, so as to gain more valuable time for emergency rescue. The core components of extracorporeal membrane oxygenation (ECMO) are the artificial lung (also called membrane lung or oxygenator) and artificial heart (also called blood pump, power pump, or pump drive). During the operation of the system, the patient's blood needs to be drawn out of the body through tubing, then pumped through the membrane lung for oxygenation by the blood pump, and finally delivered back into the body.

In the ECMO system, the device to be powered (e.g., the pump drive) (hereinafter "the target device" or "the device") is usually powered by a power supply device. When the power supply of the control host fails and cannot supply power to the target device , a battery can be used to directly supply emergency power to the device . In the existing technology, the battery directly supplies emergency power to the device , but when the battery is depleted and needs to be replaced or a new control host needs to be reconnected, the device may again experience power outage and pump stoppage. The pump stoppage operation increases the complexity of clinical operations and also increases the risk of patient treatment. Moreover, during the switching process of the power supply device or after the switch is completed, communication with the device may be interrupted, causing abnormality alarms.

### SUMMARY OF THE INVENTION

To solve or alleviate the problem of uninterrupted switching of the target device in the existing technology, in a first aspect, the present application provides a uninterrupted switching circuit, comprising a control unit, a first connector, and at least two second connectors;
the first connector is connected to a device to be powered, and the at least two second connectors are respectively connected to power supply devices; the first connector is connected to the at least two second connectors respectively, and the power supply devices are connected to the at least two second connectors supply power to the device that is connected to the first connector; the control unit is connected to the first connector and the at least two second connectors respectively; when the device is disconnected from one of the power supply devices, the control unit determines whether the power supply from another power supply device connected to the second connector to the device connected to the first connector is normal, and if the power supply is normal, the control unit feeds back a normal power supply signal to the device to be powered, thereby avoiding an abnormality alarm from being issued by the device to be powered.

In an embodiment of the present application, the first connector is respectively connected to the at least two second connectors and the control unit through power supply paths and communication paths.

In an embodiment of the present application, the control unit, the first connector, and each of the second connectors are each provided with a power interface, a first communication interface, and a second communication interface;
the power interface of the first connector and the power interface of each of the second connectors are connected to form the power supply paths, and the power interface of the control unit is connected to the power supply paths; the communication paths comprise first communication paths and second communication paths; the first communication interface of the first connector and the first communication interface of each of the second connectors are connected to form the first communication paths, and the first communication interface of the control unit is connected to the first communication paths; and the second communication interface of the first connector and the second communication interface of each of the second connectors are connected to form the second communication paths, and the second communication interface of the control unit is connected to the second communication paths.

In an embodiment of the present application, the control unit, the first connector, and each of the second connectors are each further provided with an identification interface; the identification interface of the first connector and the identification interface of each of the second connectors are connected to form identification paths, and the identification interface of the control unit is connected to the identification paths.

In an embodiment of the present application, a protection circuit is provided on the power supply path between the first connector and each of the second connectors.

In an embodiment of the present application, a diode is provided between each of the protection circuits and the first connector, an input terminal of the diode is connected to an output terminal of the protection circuit, an output terminal of each diode is connected to a common node on the power supply path and then connected to the first connector, the common node is a node where the power interface of the first connector and the power interfaces of the at least two second connectors are connected to form the power supply path.

In an embodiment of the present application, a level detection circuit is connected in series between each of the protection circuits and the corresponding diode, and each of the level detection circuits is electrically connected to the control unit.

In an embodiment of the present application, a current detection circuit is provided between the common node and the first connector, and the current detection circuit is electrically connected to the control unit.

In an embodiment of the present application, the power interface of the control unit is connected to a common terminal between the first connector and the common node, a voltage transformation circuit is provided between the common terminal and the control unit, and an output terminal of the voltage transformation circuit is connected to the control unit via a voltage stabilization circuit.

In an embodiment of the present application, the uninterrupted switching circuit further comprises a communication protocol conversion circuit, one end of the communication protocol conversion circuit is connected to the first communication paths, and the other end thereof is connected to the control unit.

In an embodiment of the present application, the first communication paths adopt CAN bus communication, and a terminal resistance self-matching circuit is provided on the first communication path.

In an embodiment of the present application, the uninterrupted switching circuit further comprises indicators corresponding in number to the at least two second connectors, the indicators are connected to the control unit and are configured to indicate a power supply status of the second connectors.

Compared with the existing technology, the embodiments of the present application connect a device and power supply devices together by the control unit, the first connector, and the second connectors. The first connector is connected to the device to be powered, and each second connector is connected to a power supply device, enabling multiple power supply devices to supply power simultaneously and allowing free switching between the power supply devices, thereby improving the reliability of the power supply devices. Moreover, by the control unit, the device can be communicatively connected with multiple power supply devices respectively, and the control unit determines the connection status between the device and the power supply devices and feeds it back to the device to be powered, thereby avoiding abnormality alarms of the device during or after a switching process.

In a second aspect, the present application provides a device, comprising the uninterrupted switching circuit according to any one of the above embodiment descriptions.

When the device provided by the present application is controlled using the uninterrupted switching circuit, it not only enables multiple power supply devices to be connected simultaneously, but also allows the power supply devices to be freely switched. At the same time, there is no need to modify or add additional circuits to the device and the power supply devices, which avoids circuit complexity, while also ensuring that it does not stop operating during the switching process, so that the device does not issue abnormality alarms.

In a third aspect, the present application provides a system, comprising the above device, the system further comprising: a device and at least two power supply devices;

The device is connected to each power supply device by the uninterrupted switching circuit.

The system provided by the present application connects a device and power supply devices by the uninterrupted switching circuit, which enables multiple power supply devices to supply power to the device and to communicate with it. This ensures the stability of power supply and communication for the device, and also realizes interconnection between the device and each power supply device. When switching power supply devices, the device does not stop operating and thus does not issue abnormality alarms.

### BRIEF DESCRIPTION OF THE DRAWINGS

The drawings described herein are provided for a further understanding of the present application and constitute a part of the present application. The illustrative embodiments of the present application and the descriptions thereof are used to explain the present application and do not constitute undue limitations on the present application. Some specific embodiments of the present application will be described in detail below by way of example and not limitation with reference to the drawings. The same reference numerals in the drawings indicate the same or similar components or parts. It should be understood by a person skilled in the art that the drawings are not necessarily drawn to scale. In the drawings:
FIG. 1 is a schematic diagram of the connection of an uninterrupted switching system according to an embodiment of the present application.
FIG. 2 is a schematic diagram of the interface connection of an uninterrupted switching circuit according to an embodiment of the present application.
FIG. 3 is a schematic diagram of a partial framework of an uninterrupted switching circuit according to an embodiment of the present application.
FIG. 4 is a schematic diagram of a protection circuit structure according to an embodiment of the present application.
FIG. 5 is a schematic diagram of the overall framework of an uninterrupted switching circuit according to an embodiment of the present application.
FIG. 6 is a schematic diagram of the terminal resistance self-matching circuit structure according to an embodiment of the present application.

In the figures:
1, control unit;
2, first connector;
3, second connector;
4, protection circuit;
5, current monitoring circuit;
6, communication protocol conversion circuit;
7, indicator;
8, device to be powered (a.k.a., the target device 8 or the device 8);
9, power supply device;
11, power supply interface of the control unit;
12, first communication interface of the control unit;
13, second communication interface of the control unit;
14, identification interface of the control unit;
21, power supply interface of the first connector;
22, first communication interface of the first connector;
23, second communication interface of the first connector;
24, identification interface of the first connector;
31, power supply interface of the second connector;
32, first communication interface of the second connector;
33, second communication interface of the second connector;
34, identification interface of the second connector;
41, diode;
42, level monitoring circuit;
51, voltage transformation circuit; and
52, voltage stabilization circuit.

### DESCRIPTION OF THE EMBODIMENTS

To enable a person skilled in the art to better understand the solutions of the present application, the technical solutions in the embodiments of the present application will be clearly and completely described below in conjunction with the accompanying drawings in the embodiments of the present application. Obviously, the described embodiments are merely some rather than all of the embodiments of the present application. Based on the embodiments in the present application, all other embodiments obtained by a person of ordinary skill in the art without creative effort shall fall within the scope of protection of the present application.

The uninterrupted switching circuit of the present application is applied to the ECMO field but is not limited to the ECMO field. ECMO is an important technology used to maintain the cardiopulmonary function of patients. ECMO replaces the function of damaged lungs or heart by drawing blood from the body's circulation, oxygenating it, and then transporting it back into the body.

The ECMO system includes an oxygenator, a pump drive (device 8), and a power supply device 9. The power supply device 9 can be a control host and/or a battery. The uninterrupted switching circuit provided by the present application aims to solve the technical problem of the pump drive (device 8) not experiencing power failure and abnormality alarms during the switching process between the control host and the battery.

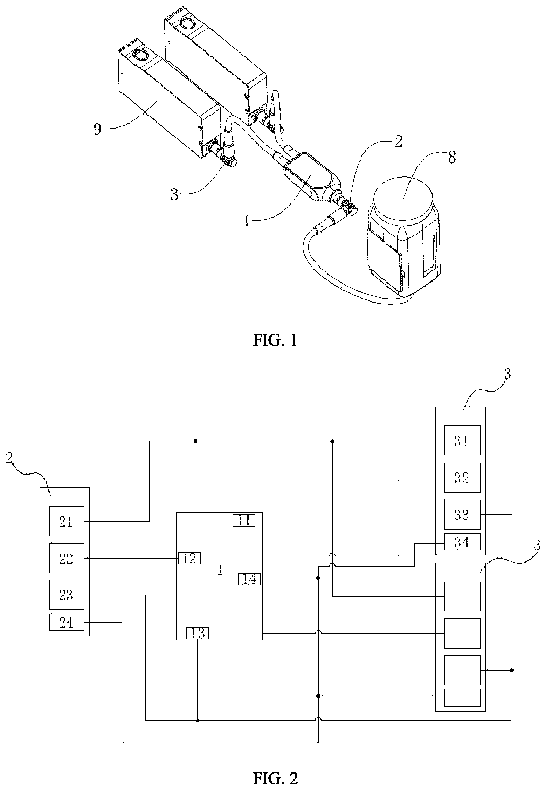

In a first aspect, as shown in FIG. 1, the present application provides an uninterrupted switching circuit, including a control unit 1, a first connector 2, and at least two second connectors 3;
The first connector 2 is connected to a device 8, and the at least two second connectors 3 are respectively connected to a power supply device(s) 9. The first connector 2 is connected to each of the at least two second connectors 3, and the power supply device(s) 9 connected to the at least two second connectors 3 supplies power to the device 8 connected to the first connector 2; The control unit 1 is respectively connected to the first connector 2 and the at least two second connectors 3.

When the device 8 is disconnected from a portion of the power supply device(s) 9, the control unit 1 determines whether the other portion of the power supply device(s) 9 connected to the second connector 3 is supplying power normally to the device 8 connected to the first connector 2. If it is, the control unit 1 feeds back a power supply normal signal of the power supply device(s) 9 to the device 8, thereby avoiding abnormality alarms of the device 8.

In the embodiments of the present application, the device 8 and the power supply device(s) 9 are connected together through the control unit 1, the first connector 2, and the second connector 3. The first connector 2 is connected to the device 8, and each second connector 3 is connected to the power supply device(s) 9, which can realize simultaneous power supply to the device 8 by multiple power supply devices 9, and the power supply devices 9 can be freely switched, realizing uninterrupted power for the device 8. In addition, by providing the control unit 1, the device 8 can be communicatively connected to the multiple power supply devices 9 respectively, and the control unit 1 determines the connection status between the device 8 and the power supply devices 9 and feeds it back to the device 8, thereby avoiding abnormality alarms of the device 8 during or after a switching process.

Preferably, the first connector 2 adopts a female connector with waterproof function, and the second connector 3 adopts a male connector with waterproof function.

Preferably, the control unit 1 is an MCU.

More specifically, in the ECMO system, the pump drive can be electrically and communicatively connected to a battery, a control host, or other external devices simultaneously through this uninterrupted switching circuit to form multiple paths. This enables multiple devices to supply power to the pump drive. When switching between the battery, control host, or other external devices, the battery, control host, or external devices in other paths can continue to supply power to the pump drive, ensuring that the pump drive does not stop running during a switching process. In this case, when the control unit detects that another path is supplying power continuously to the pump drive, it sends a normal switching signal to the pump drive, avoiding abnormality alarms of the pump drive.

In one embodiment, the first connector 2 is connected to the at least two second connectors 3 and the control unit 1 through a power supply path and a communication path, respectively.

In the embodiments of the present application, the power supply path is used to supply power to the device 8 and the control unit 1, while the communication path is used for the exchange of information and data between the device 8, the control unit 1, and each power supply device 9, including connection status information, voltage, current, power, and other data of the power supply devices 9. Through the information and data exchange between the power supply path and the communication path, abnormality alarms of the device 8 can be avoided during or after a switching process.

More specifically, when the switched power supply device 9 is a battery, and the control unit 1 monitors that the connection between the battery and the corresponding second connector 3 of the path is disconnected, if it is monitored that there is no power supply voltage in this power supply path, and a power supply voltage is detected in the power supply path of another second connector 3, it is determined that the battery is switched normally, and the device 8 is notified that the battery is switched normally, and the issuance of abnormality alarms is stopped.

When the switched power supply device 9 is a control host, and the control unit 1 monitors that the connection of the control host is disconnected, if it is simultaneously monitored that the power supply voltage of this power supply path continues to exist, it is determined that the communication of the control host is abnormal. In this case, the device 8 is notified that the control host is abnormally switched, and an abnormality alarm can be issued.

When the power supply device 9 undergoes a normal switch, an operator will disconnect the corresponding second connector 3. The control unit 1 monitors that the power supply path and the communication path of the power supply device 9 are disconnected simultaneously. However, if only the communication disconnection of the power supply device 9 is monitored, while the power supply voltage still exists, it indicates that the second connector 3 of the power supply device 9 has not been unplugged for switching. In this case, the communication between the control unit 1 and the internal components of the power supply device 9 is abnormal. At this time, the control unit 1 can send the corresponding communication abnormal signal to the device 8, and the device 8 then issues a corresponding alarm to the operator to remind the operator to troubleshoot the fault.

As shown in FIG. 2, in one embodiment, the control unit 1, the first connector 2, and each second connector 3 are all provided with a power supply interface, a first communication interface, and a second communication interface.

The power supply interface 21 of the first connector and the power supply interface 31 of each second connector are connected to form a power supply path, and the power supply interface 11 of the control unit is connected to the power supply path.

The communication path includes a first communication path and a second communication path.

The first communication interface 22 of the first connector and the first communication interface 32 of each second connector are connected to form a first communication path, and the first communication interface 12 of the control unit is connected to the first communication path.

The second communication interface 23 of the first connector and the second communication interface 33 of each second connector are connected to form a second communication path, and the second communication interface 13 of the control unit is connected to the second communication path.

In the embodiments of the present application, the power supply interface includes a power negative interface and a power positive interface. The first communication path adopts CAN bus communication, which is used for the transmission of information and data between the control unit 1, the device 8, and the power supply devices 9. The second communication path adopts I2C communication, which is used to obtain information such as voltage, current, and power of the power supply devices 9, where the first communication interface 22 of the first connector and the first communication interface 32 of the second connector both include a CAN bus communication pin CAN H and a CAN bus communication pin CAN L.

By means of connecting the power supply interfaces, the first communication interfaces, and the second communication interfaces of the control unit 1, the first connector 2, and each second connector 3 to each other, mutual coordination between data can be achieved. The control unit 1 can communicate with the device 8 and the power supply devices 9 (i.e., the control host or battery) respectively. When the communication connection between the device 8 and the power supply devices 9 is disconnected, the control unit 1 can still communicate with the device 8 and feed back signals to inform the device 8, thereby avoiding abnormality alarms of the device 8.

Specifically, the power supply device 9 supplies power to the device 8 and the control unit 1 through the power supply path; the power supply devices 9 transmit communication signals to the control unit 1 and the device 8 through the first communication path and the second communication path. Simultaneously, the device 8, the power supply devices 9, and the control unit 1 can also transmit communication signals to each other through the first communication path and the second communication path.

Moreover, the control unit 1 can also determine whether the power supply devices 9 have been normally connected to the device 8, so that the power supply devices 9 can supply power to the device 8, ensuring continuous and reliable power supply to the device 8.

The present application sets the power supply of the circuit by directly connecting the first connector 2 with multiple second connectors 3. Each second connector 3 can be connected to a power supply device 9, and the connection between the second connector 3 and the power supply device 9 enables power to be delivered to to the device 8. Moreover, the power supply is not controlled by the on/off control of the control unit 1. Therefore, even if the control unit 1 fails or the power supply device 9 connected to one of the second connectors 3 fails or is being switched, the power supply device 9 can still normally supply power to the device 8. By using multiple power supply devices 9 in parallel, the reliability and continuity of the power supply to the device 8 are greatly improved.

Furthermore, the communication paths are the same. Even if the control unit 1 fails or the power supply device 9 connected to one of the second connectors 3 fails or is being switched, the device 8 can still normally communicate with another power supply device 9, thereby greatly improving the reliability of the communication connection.

In one embodiment, the control unit 1, the first connector 2, and each second connector 3 are further provided with an identification interface.

The identification interface 24 of the first connector and the identification interface 34 of each second connector are connected to form an identification path, and the identification interface 14 of the control unit is connected to the identification path.

In the embodiments of the present application, when the power supply device 9 is connected to the second connector 3, and the device 8 is connected to the first connector 2, the power supply device 9 monitors the connection status of the device 8 through the identification path connected to the identification interface 14 of the control unit. If it is monitored that the device 8 is connected, the power supply device 9 starts supplying power. In addition, the control unit 1 can also detect whether the device 8 is connected to the uninterrupted switching device through the identification interface 14 of the control unit.

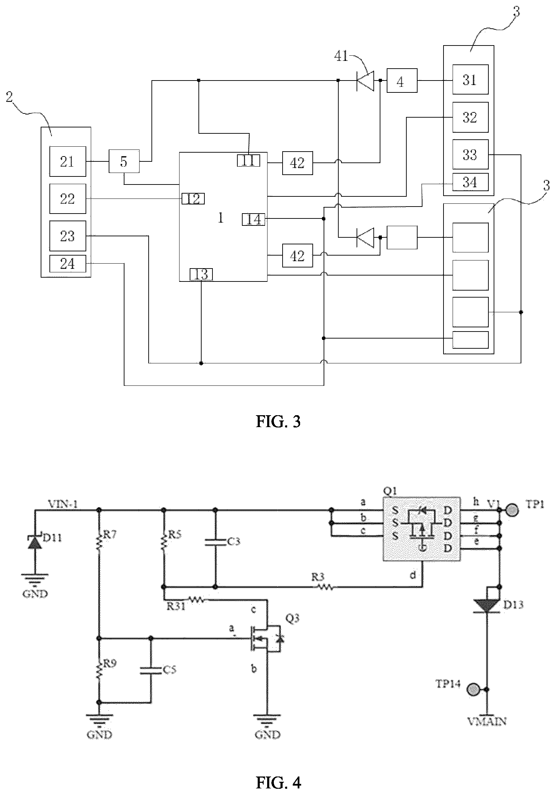

As shown in FIG. 3, in one embodiment, a protection circuit 4 is provided on the power supply path between the first connector 2 and each second connector 3.

In the embodiments of the present application, the protection circuit 4 is a hot-swappable protection circuit. With this hot-swappable protection circuit, the problem of sparks generated at the connection terminals when connecting redundant circuits while the device 8 is running can be solved, avoiding electric shock to the operator or damage to internal electronic devices caused by sparks. At the same time, it can also prevent electrical faults and damage to the device 8 caused by current surges or short circuits when switching the power supply devices 9 while the device 8 is running.

In one embodiment, a diode 41 is provided between each protection circuit 4 and the first connector 2. The input terminal of the diode 41 is connected to the output terminal of the protection circuit 4, and the output terminals of each diode 41 are connected to the first connector 2 after being connected to a common node on the power supply path. The common node is a node where the power supply interface 21 of the first connector is connected to the common terminal after being connected to the power supply interfaces of the at least two second connectors 3 to form the power supply paths.

As shown in FIG. 4, in one embodiment, the protection circuit includes a diode D11, with the input terminal of the diode D11 grounded. The output terminal of the diode D11 is connected in parallel with a resistor R7, a resistor R5, and a capacitor C3. The other terminal of the resistor R7 is connected in series with a resistor R9 and then grounded. The common node VIN-1 between the output terminal of the diode D11 and the resistor R7, the resistor R5, and the capacitor C3, serves as the input terminal and is connected to the positive terminal of the power supply port 31 of the first connector 2. The other terminal of the resistor R5 is connected in series with a resistor R31 and then connected to the collector of a transistor Q3. The base of the transistor Q3 is grounded, and the emitter of the transistor Q3 is connected to the common node between the resistor R7 and the resistor R9. A capacitor C5 is connected in series between the grounded terminal of the resistor R9 and the emitter of the transistor Q3. The other terminal of the capacitor C3 is connected in series with the resistor R3 and then connected to port d of a field-effect switch Q1. The common node between the capacitor C3 and the resistor R3 is connected to the common node between the resistor R5 and the resistor R31. Ports a, b, and c of the field-effect switch Q1 are connected in parallel and then connected to the output terminal of the diode D11. Ports e, f, g, and h of the field-effect switch Q1 are connected in parallel and then connected to the common node V1 of a diode D13 as the output terminal, and connected to the input terminal of the diode 41. Test points TP1 and TP14 are respectively provided at the input and output terminals of the diode D13.

In the embodiments of the present application, VIN-1 is the input terminal and V1 is the output terminal. When VIN-1 is not inserted, it is at a low level. When port a of the transistor Q3 is at a low level, the transistor Q3 is in a cutoff state. When the input terminal VIN-1 is connected to a power source, port a of the transistor Q3 causes the transistor Q3 to conduct with a delay through a voltage divider and an RC circuit composed of R7/R9/C5. When the transistor Q3 is not in the cutoff state, port d of the field-effect switch Q1 is pulled high by the input terminal VIN-1, and the field-effect switch Q1 is in the cutoff state, so the output terminal V1 has no output level. When transistor Q3 turns on, it pulls down port d of the field-effect switch Q1 to a low level, causing the field-effect switch Q1 to be in a conducting state, and the output terminal V1 outputs a level. The voltage of the input terminal VIN-1 is controlled through the combination of the transistor Q3 and the field-effect switch Q1. Combined with other resistorcapacitor circuits, a soft-start function can be realized for sudden level changes at the input terminal, limiting overvoltage and overcurrent conditions during plug contact, and ensuring that the output terminal V1, as the output terminal, provides a stable level power supply.

In the embodiments of the present application, by providing a diode 41 between each protection circuit 4 and the first connector 2, it is possible to effectively prevent interference when multiple second connectors 3 are connected in parallel, ensuring that for the connection of various power supply devices (with different voltages), the use of the device can always be satisfied.

In one embodiment, a level detection circuit 42 is connected in series between each protection circuit 4 and the corresponding diode 41, and each level detection circuit 42 is electrically connected to the control unit 1.

In this embodiment, by providing the level detection circuit 42 between each protection circuit 4 and the corresponding diode 41, the purpose is to monitor the voltage at the input terminal of each second connector 3. The level detection circuit uses a voltage divider resistor for monitoring, and the monitored voltage signal is output to the control unit 1. The control unit 1 can then determine whether this voltage meets the usage requirements of the device 8, and if not, an abnormality alarm will be issued.

In one embodiment, a current detection circuit 5 is provided between the common node and the first connector 2, and the current detection circuit 5 is electrically connected to the control unit 1.

In the embodiments of the present application, the current detection circuit 5 adopts a series sampling resistor in the circuit, and the current in the path is collected through a current collector. The collected signal is transmitted to the control unit 1, and the control unit 1 then calculates the current flowing through the sampling resistor. In this case, the control unit 1 determines whether the operation of the device 8 is "normal" based on the input current. If it is abnormal, an alarm signal will be immediately sent to the device 8. At the same time, the input current of the device 8 can be collected in real time, and the power consumption of the device 8 can be determined based on the input voltage monitored at the second connector 3. As a result, the remaining power percentage of the power supply device 9 can be calculated, and the remaining power supply time of the power supply device 9 can be accurately estimated and provided to a user as an accurate reference for the usage time of the power supply device 9, so as to avoid power supply interruption caused by the user's failure to replace the power supply device 9 in time due to insufficient preparation.

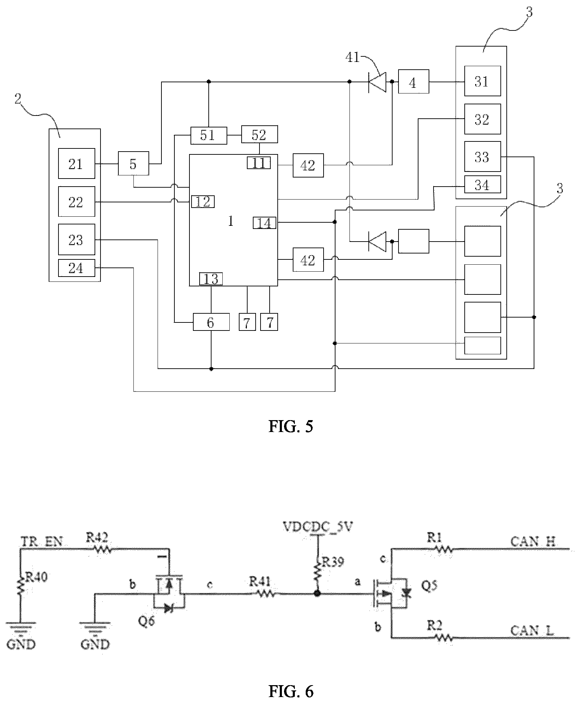

As shown in FIG. 5, in one embodiment, the power supply interface 11 of the control unit is connected to the common terminal between the first connector 2 and the common node. A voltage transformation circuit 51 is provided between the common terminal and the control unit 1, and the output terminal of the voltage transformation circuit 51 is connected to the control unit 1 through a voltage stabilization circuit 52.

In the embodiments of the present application, the voltage transformation circuit 51 adopts a DC step-down circuit. The voltage transformation circuit 51 mainly supplies power to the control unit 1 and other monitoring circuits. The input terminal of the DC step-down circuit is connected to the output terminal of diode 41, and the output terminal of the DC step-down circuit supplies power to the control unit 1 after being stabilized by the voltage stabilization circuit 52. The DC step-down circuit adopts a DC-DC step-down device for voltage reduction, and the voltage stabilization circuit 52 adopts an LDO regulator to supply power to the control unit 1. The purpose is to ensure stable and reliable power supply for the control unit 1.

In one embodiment, a communication protocol conversion circuit 6 is further provided, with one terminal of the communication protocol conversion circuit 6 connected to the first communication path, and the other terminal connected to the control unit 1.

In the embodiments of the present application, the communication protocol conversion circuit 6 is a CAN conversion circuit. The CAN conversion circuit is used to convert the differential signal of the CAN bus into a signal level suitable for the node circuit. It is responsible for signal level conversion and interface matching between the control unit 1 and CAN bus communication.

In one embodiment, the communication protocol conversion circuit 6 is also connected to the voltage transformation circuit 51, and is powered by the voltage transformation circuit 51.

In the embodiments of the present application, the voltage transformation circuit 51 is connected to the communication protocol conversion circuit 6 for the purpose of supplying power to the communication protocol conversion circuit 6 through the voltage transformation circuit 51.

In one embodiment, the first communication path adopts CAN bus communication, and a terminal resistance self-matching circuit is provided on the first communication path.

In the embodiments of the present application, in the CAN bus communication circuit, by providing a terminal resistance self-matching circuit, the problem that CAN bus communication cannot be performed due to the device 8 being connected to different power supply devices 9 or not connected to external devices can be resolved. The terminal resistance self-matching circuit can achieve the effect of matching and coordinating the communication signals between different power supply devices 9 and the device 8, as well as enhancing the signal.

As shown in FIG. 6, in one embodiment, the terminal resistance self-matching circuit includes a transistor Q5 and a transistor Q6. The emitter of the transistor Q5 is connected to the collector of the transistor Q6. The base of the transistor Q5 is connected to the CAN bus communication pin CAN L after being connected in series with a resistor R2. The collector of the transistor Q5 is connected to the CAN bus communication pin CAN H after being connected in series with a resistor R1. The base of the transistor Q6 is grounded. The emitter of the transistor Q6 is grounded after being connected in series with a resistor R42 and a resistor R40. A resistor R41 is connected in series between the emitter of the transistor Q5 and the collector of the transistor Q6. A resistor R39 is connected in parallel with the common node between the resistor R41 and the emitter of the transistor Q5. The other terminal of the resistor R39 is connected to the power supply.

The common node TR EN of the resistor R40 and the resistor R42 is connected to the control pin of the control unit MCU.

In the embodiments of the present application, when the device power supply is turned on and enters the default state, the DC-DC converter provides a 5V level, and the common node TR_EN is pulled down to a default low level by the resistor R40. The common node TR_EN, through the current-limiting resistor R42, causes the level of a first port (not shown, but similar to port f of the field effect switch Q1 in FIG. 4) of the transistor Q6 to be at a low level, and the transistor Q6 is in the cutoff state. A second port (not shown, but similar to port a of the field effect switch Q1 in FIG. 4) of the transistor Q5 forms a high level state through a 5V pull-up circuit, and the transistor Q5 is in the cutoff state. The CAN bus communication pin CAN H and the CAN bus communication pin CAN L are in a disconnected state, forming a circuit without terminal resistance. When the control unit MCU controls the common node TR_EN to become a high level, the transistor Q6 is in the conducting state, pulling down the level of a third port (not shown, but similar to port c of the field effect switch Q 1 in FIG. 4) of the transistor Q6, and at the same time, the level of port a of the transistor Q5 is pulled down. The transistor Q5 changes to the conducting state, and CAN H and CAN L are connected through R1 + R2, forming a circuit with added terminal resistance. By controlling the high and low levels of the common node TR_EN through the control unit MCU, the on/off state of the transistor Q6 can be controlled, and further the on/off state of the transistor Q5 can be controlled, thereby realizing the adjustment of the two connection states of the CAN bus communication pin CAN H and the CAN bus communication pin CAN L being in a disconnected state and in a series connection of resistors R1 and R2.

In one embodiment, it further includes indicators 7 corresponding in number to the second connectors 3. The indicators 7 are connected to the control unit 1 and are used to indicate the power supply status of the second connectors 3.

In the embodiments of the present application, when a second connector 3 is connected to a power supply device 9, the circuit of the present application detects whether its input voltage meets the power supply requirements of the device 8. If the requirements are met, a correct reminder is given to the user through the indicator 7. If the voltage is abnormal, no reminder is given or an abnormal indication is provided. In this way, it avoids the situation where the user connects a power supply device 9 with insufficient power to the device 8, which may lead to a sudden power outage during switching.

In a second aspect, an embodiment of the present application provides a device, including the uninterrupted switching circuit described in the above embodiments.

In the embodiments of the present application, when the device adopts the uninterrupted switching circuit of the present application for control, it can realize simultaneous power-on of multiple power supply devices 9, and the power supply devices 9 can be freely switched while the device 8 will not stop operating, and moreover, no abnormality alarm will be triggered.

In a third aspect, an embodiment of the present application provides a system, characterized in that it includes the device of the above embodiment, and the system further includes: a device 8 and at least two power supply devices 9.

The device 8 is connected to each power supply device 9 through the device.

In the embodiments of the present application, the system connects the device 8 and the power supply devices 9 through the above device, which can realize power supply to the device 8 by multiple power supply devices 9, ensuring the power supply stability of the device 8. It also realizes the flexibility of interconnection between the device 8 and each power supply device 9. When switching the power supply devices 9, no abnormality alarm will be issued.

It should be noted finally that the above embodiments are only used to illustrate the technical solutions of the present application, and not to limit them. Although the present application has been described in detail with reference to the foregoing embodiments, a person skilled in the art should understand that modifications may still be made to the technical solutions described in the foregoing embodiments, or equivalent replacements may be made to some or all of the technical features therein. These modifications or replacements do not cause the essence of the corresponding technical solutions to depart from the scope of the technical solutions of the embodiments of the present application.

## Claims

1. A uninterrupted switching circuit comprising:
a control unit;
a first connector; and
at least two second connectors; wherein:
the first connector is configured to be connected to a target device, and the at least two second connectors are respectively configured to be connected to power supply devices;
the first connector is connected to the at least two second connectors, respectively, to enable the power supply devices to supply power to the target device through the first connector;
the control unit is connected to the first connector and the at least two second connectors, respectively;
the control unit is configured to, in response to detecting that the target device is disconnected from one of the power supply devices, determine whether another power supply device connected to the target device through one of the second connectors is normal, and, in response to determining that the power supply is normal, the control unit is configured to feed back a normal power supply signal to the target device, thereby avoiding an abnormality alarm from being issued by the target device.

2. The uninterrupted switching circuit according to claim 1, wherein the first connector is respectively connected to the at least two second connectors and the control unit through power supply paths and communication paths.

3. The uninterrupted switching circuit according to claim 2, wherein:
the control unit, the first connector, and each of the second connectors are each provided with a power interface, a first communication interface, and a second communication interface;
a power interface of the first connector and a power interface of each of the second connectors are connected to form power supply paths, and a power interface of the control unit is connected to the power supply paths;
the communication paths comprise first communication paths and second communication paths;
a first communication interface of the first connector and a first communication interface of each of the second connectors are connected to form the first communication paths, and a first communication interface of the control unit is connected to the first communication paths; and
a second communication interface of the first connector and a second communication interface of each of the second connectors are connected to form the second communication paths, and a second communication interface of the control unit is connected to the second communication paths.

4. The uninterrupted switching circuit according to claim 2, wherein:
the control unit, the first connector, and each of the second connectors are each further provided with an identification interface;
an identification interface of the first connector and an identification interface of each of the second connectors are connected to form identification paths, and an identification interface of the control unit is connected to the identification paths.

5. The uninterrupted switching circuit according to claim 2, further comprising a protection circuit on power supply paths between the first connector and each of the second connectors.

6. The uninterrupted switching circuit according to claim 5, further comprising a diode between each of the protection circuits and the first connector, wherein an input terminal of the diode is connected to an output terminal of the respective protection circuit, an output terminal of each diode is connected to a common node on the respective power supply path and then connected to the first connector, wherein the common node is a node where the power interface of the first connector and the power interfaces of the at least two second connectors are connected to form the power supply path.

7. The uninterrupted switching circuit according to claim 6, further comprising a level detection circuit connected in series between each of the protection circuits and the corresponding diodes, wherein each of the level detection circuits is electrically connected to the control unit.

8. The uninterrupted switching circuit according to claim 6, further comprising a current detection circuit provided between the common node and the first connector, wherein the current detection circuit is electrically connected to the control unit.

9. The uninterrupted switching circuit according to claim 8, wherein the power interface of the control unit is connected to a common terminal between the first connector and the common node, a voltage transformation circuit is provided between the common terminal and the control unit, and an output terminal of the voltage transformation circuit is connected to the control unit via a voltage stabilization circuit.

10. The uninterrupted switching circuit according to claim 3, further comprising a communication protocol conversion circuit, wherein one end of the communication protocol conversion circuit is connected to the first communication paths, and the other end thereof is connected to the control unit.

11. The uninterrupted switching circuit according to claim 3, wherein the first communication paths adopt CAN bus communication, and a terminal resistance self-matching circuit is provided on the first communication path.

12. The uninterrupted switching circuit according to claim 1, further comprising indicators corresponding in number to the at least two second connectors, wherein the indicators are connected to the control unit and are configured to indicate a power supply status of the second connectors.

13. A target device comprising the uninterrupted switching circuit according to claim 1.

14. A system comprising the target device according to claim 13 and at least two power supply devices, wherein the target device is connected to each of the power supply devices through the uninterrupted switching circuit.
